Europäisches Patentamt

(19) European Patent Office

Office européen des brevets

(11) EP 0 573 798 B1

(12) **EUROPÄISCHE PATENTSCHRIFT**

(45) Veröffentlichungstag und Bekanntmachung des Hinweises auf die Patenterteilung:
**29.01.1997 Patentblatt 1997/05**

(51) Int. Cl.$^6$: **C04B 35/00**, C04B 101/00

(21) Anmeldenummer: **93107621.0**

(22) Anmeldetag: **11.05.1993**

(54) **Verfahren zur Herstellung eines Hochtemperatursupraleiters und daraus gebildeter Formkörper**

Process for producing high-temperature superconductor and shaped product thereof

Procédé de fabrication d'un supraconducteur de haute température et un article à base de ce matériau

(84) Benannte Vertragsstaaten:
**AT BE CH DE DK ES FR GB GR IT LI NL SE**

(30) Priorität: **10.06.1992 DE 4218950**

(43) Veröffentlichungstag der Anmeldung:
**15.12.1993 Patentblatt 1993/50**

(73) Patentinhaber: **HOECHST AKTIENGESELLSCHAFT 65926 Frankfurt am Main (DE)**

(72) Erfinder:
• **Bock, Joachim, Dr.**
**W-5042 Erftstadt (DE)**
• **Preisler, Eberhard, Dr.**
**W-5042 Erftstadt (DE)**

(56) Entgegenhaltungen:
**EP-A- 0 285 169      EP-A- 0 362 492**
**EP-A- 0 369 464      EP-A- 0 462 409**
**EP-A- 0 524 442**

• **PATENT ABSTRACTS OF JAPAN vol. 16 no. 315 (C-961) ,10.Juli 1992 & JP-A-04 089361 (FURUKAWA ELEC CO LTD) 23.März 1992,**
• **DATABASE WPI Section Ch, Week 9122 Derwent Publications Ltd., London, GB; Class L03, AN 91-161049 & JP-A-03 097 658 (CHISSO CORP) , 23.April 1991**
• **DATABASE WPI Section Ch, Week 8931 Derwent Publications Ltd., London, GB; Class L03, AN 89-224405 & JP-A-01 160 861 (MITSUBISHI DENKI KK) , 23.Juni 1989**
• **DATABASE WPI Section Ch, Week 8851 Derwent Publications Ltd., London, GB; Class E32, AN 88-364699 & JP-A-63 274 698 (NIPPON TELEG & TELEPH) , 11.November 1988**
• **PATENT ABSTRACTS OF JAPAN vol. 16 no. 315 (C-961) ,10.Juli 1992 & JP-A-04 089361**
• **DATABASE WPI Section Ch, Week 9122 Derwent Publications Ltd., London, GB; Class L03, AN 91-161049 & JP-A-03 097 658**
• **DATABASE WPI Section Ch, Week 8931 Derwent Publications Ltd., London, GB; Class L03, AN 89-224405 & JP-A-01 160 861**
• **DATABASE WPI Section Ch, Week 8851 Derwent Publications Ltd., London, GB; Class E32, AN 88-364699 & JP-A-63 274 698**

**Beschreibung**

Die Erfindung betrifft ein Verfahren zur Herstellung eines Hochtemperatursupraleiters und daraus gebildeter Formkörper, bestehend aus Oxiden des Bismuts, Strontiums, Calciums, Kupfers und ggf. des Bleis, sowie Sulfaten des Strontiums und/oder des Bariums.

Aus der DE 38 30 092 A1 ist ein Verfahren zur Herstellung eines Hochtemperatursupraleiters (HTSL) der Zusammensetzung $Bi_2(Sr,Ca)_3Cu_2O_x$ mit Werten für x von 8 bis 10 bekannt. Dabei werden stöchiometrische Mischungen der Oxide oder Carbonate von Bismut, Strontium, Calcium und Kupfer auf Temperaturen von 870 bis 1100 °C unter Bildung einer homogenen Schmelze erhitzt. Diese Schmelze wird in Kokillen vergossen und erstarrt langsam darin. Die aus den Kokillen entnommenen Gußkörper werden 6 bis 30 Stunden lang bei 780 bis 850 °C getempert und anschließend mindestens 6 Stunden bei 600 bis 830 °C in Sauerstoff enthaltender Atmosphäre behandelt. Auf diese Weise lassen sich nicht nur Kleinproben, sondern Formkörper vergleichsweise großer Abmessungen, wie z.B. Stäbe mit Längen bis zu 0,5 m, Platten von mehreren cm Kanten-länge und einigen mm Dicke oder durch eine Variante des Verfahrens, dem Schleudergießen entsprechend EP-0 462 409 A1, auch Hohlzylinder z.B. von 20 cm Durchmesser und 10 cm Höhe herstellen. In diese Formkörper oder Massivteile lassen sich feste Edelmetallteile integrieren und nach Temperaturbehandlung so mit dem Supraleitermaterial verbinden, daß Stromkontakte mit sehr geringen Übergangswiderständen entstehen.

Für supraleitende Formkörper der genannten Art, mit oder ohne Stromkontakte, ergeben sich zukünftige Anwendungen im Bereich der Elektrotechnik. Eine der ersten Anwendungen werden voraussichtlich Stromzuführungen für Tieftemperatur-Supraleiter sein. Ein Ersatz der bisher benutzten konventionellen Cu-Zuleitungen durch HTSL-Keramik würde zu wesentlich verringertem Verbrauch an Helium als Kühlmittel führen, da die Wärmeleitfähigkeit der Keramik erheblich geringer ist als die von metallischem Kupfer und unterhalb der Sprungtemperatur im Supraleiter keine Widerstandsverluste auftreten, die sonst zu einem weiteren Wärmeeintrag in das flüssige Helium führen würden.

Der Einsatz neuer Stromzuführungen anstelle des konventionellen Materials wird daher um so lohnender, je höher die Ströme sind, die damit transportiert werden sollen. Voraussetzung auch für andere Anwendungen von HTSL-Bauteilen in der Elektrotechnik ist, daß Ströme in der Größenordnung von 1 kA transportiert werden können.

Ein Nachteil bei der Herstellung von HTSL-Bauteilen durch das Verfahren der DE 38 30 092 A1, welches das Vergießen einer homogenen Schmelze beinhaltet, war bisher, daß die zur Herstellung der homogenen Schmelze verwendeten handelsüblichen Tiegel aus Korund stark durch die Bismut enthaltenden Schmelzen angegriffen werden. Zusätzlich wird das Tiegelmaterial durch die starken Temperaturwechsel bei dem Verfahren beansprucht: Entnahme des Schmelztiegels bei 1000 °C aus dem Ofen.

Zum einen hat dies geringe Standzeiten für die Korundtiegel zur Folge. Bereits nach 2 Güssen aus einem Tiegel bilden sich in einigen Fällen Risse, die eine weitere Verwendung dieser Tiegel - schon wegen der notwendigen sicheren Handhabung der Metallschmelzen - nicht mehr zulassen.

Noch gravierender ist, daß infolge der Korrosion des Tiegels das HTSL-Material durch Aluminium kontaminiert wird. Es lassen sich signifikante Mengen Aluminium im fertigen HTSL-Material nachweisen. Typischerweise liegen die Gehalte bei etwa 2000 ppm Al, wenn bei 1030 °C für ca. 15 min geschmolzen wird. Die Werte steigen bei Erhöhung der Schmelztemperatur und bei längerem Verweilen im schmelzflüssigen Zustand.

Um die Standzeiten der Tiegel zu verlängern und die Kontamination durch Aluminium zu minimieren, werden die Schmelztemperatur so niedrig wie möglich und die gewählte Aufschmelzdauer so kurz wie nötig gewählt. Es kann nur eine Schmelze hergestellt werden, die gerade eben gießfähig ist. Dies hat zusätzliche Nachteile:

1. Es besteht die Gefahr, daß die Schmelze nicht vollständig homogen ist, sondern noch feste Ausgangsbestandteile enthält. Das ist besonders dann der Fall, wenn das Verhältnis der Erdalkalimetall- zu Bismutgehalte größer als 3 zu 2 wird oder wenn Zuschlagstoffe ($SrSO_4$, $BaSO_4$) verwendet werden. Diese Zuschlagstoffe haben vor allem den Sinn, Rißbildungen in den keramischen Formkörpern zu unterdrücken. Unkontrolliert auftretende, nicht supraleitende Ausscheidungen im fertigen Supraleitermaterial sind aber nicht tolerabel, da sie unter Strombelastung zu Instabilitäten in Form sog. "hot spots" führen. Außerdem wirken sich diese Inhomogenitäten nachteilig auf die mechanischen Eigenschaften von Formkörpern, z.B. von Stäben aus.

2. Bedingt durch die niedrigen Schmelztemperaturen ist die Schmelze so viskos und erstarrt nach dem Guß so schnell, daß das Vergießen in Formen von kleinen Querschnitten oder über längere Strecken stark erschwert wird. Beispielsweise ist das Vergießen einer Schmelze der Oxide von Metallen der molaren Zusammensetzung $Bi_2Sr_2CaCu_2O_x$ mit 9 Gew.-% $SrSO_4$-Zuschlag in rohrförmige Kokillen von Durchmessern < 8 mm nicht möglich.

3. Die aus der Schmelze hergestellten Schmelzgußteile, bestehend aus den Oxiden von Bismut, Strontium, Calcium und Kupfer, verfügen nur über ein Stromtragevermögen (kritische Stromdichte) im Bereich von $10^2$ $A/cm^2$ und sind damit für die genannten technischen Anwendungen nur bedingt geeignet. Dieser Nachteil wird z.T. durch die schon erwähnte Zugabe von Sulfaten des Strontiums oder Bariums, die dem aufzuschmelzenden Oxidgemisch zugemischt werden, vermieden. An stäbchenförmigen Proben mit dem Querschnitt 0.12 cm$^2$ konnten so erstmalig Stromdichten von mehr als 1000 A/cm$^2$ erreicht werden.

Systematische Untersuchungen an stabförmigen Proben von bereits technisch relevanten Dimensionen (0.5 cm$^2$ Querschnitt und 150 mm Länge) zeigen, daß die Stromdichten noch nicht die notwendige Reproduzierbarkeit aufweisen, die von einem in der Elektrotechnik eingesetzten Material gefordert wird. In einem technischen Prozeß nur schwer kontrollierbare Parameter, beispielsweise, wie häufig die Korundtiegel zum Herstellen der Schmelze verwendet wurden, spielen eine Rolle. Ergebnisse einer solchen Versuchsreihe gehen aus der folgenden Tabelle 1 hervor:

Tabelle 1

| Kritische Stromdichten von Stabproben (8 mm Durchmesser) mit SrSO$_4$-Zusatz; Herstellung durch Vergießen aus Korundtiegeln | | |
|---|---|---|
| Anzahl der Güsse pro Tiegel | Kritische Stromdichte [A/cm$^2$] | |
| | 3 % SrSO$_4$ | 6 % SrSO$_4$ |
| 1 | 669 | 889 |
| | 568 | 900 |
| 2 | 607 | 858 |
| | 785 | 558 |
| 3 | 701 | 444 |
| | 837 | 607 |
| 4 | 680 | 382 |
| | 465 | 425 |
| 5 | 285 | 393 |
| | 640 | 680 |

Aus jeweils einem fabrikneuen Tiegel wurden Schmelzen mit 3 % bzw. 6 % SrSO$_4$-Zuschlag ein- bis fünfmal vergossen. Jedes Experiment wurde doppelt durchgeführt und anschließend wurden die kritischen Stromdichten bestimmt. Aus der Tabelle 1 ist zu ersehen, daß die Absolutwerte der kritischen Stromdichten mit der Anzahl der Güsse aus jeweils demselben Tiegel abnehmen, wobei die Schwankungen zwischen den Einzelproben zunehmen.

Andere keramische Materialien wie stabilisiertes Zirkonoxid oder dicht gesintertes Magnesiumoxid sind als Tiegelmaterialien ebenfalls ungeeignet, da die vergleichsweise geringen Temperaturwechselbeständigkeiten dieser Materialien die Durchführung des Verfahrens in der beschriebenen Art und Weise nicht erlauben.

Tiegel aus Nickel oder dicht gesintertem Aluminiumnitrid verfügen zwar über eine genügende Temperaturwechselbeständigkeit, unterliegen jedoch so stark der Korrosion durch die Schmelze, daß sie völlig ungeeignet sind.

Aufgabe der vorliegenden Erfindung ist es daher, das bestehende Verfahren so zu modifizieren, daß die erwähnten Nachteile und Beschränkungen überwunden werden.

Überraschenderweise wurde nun gefunden, daß die kritischen Stromdichten in Massivteilen (Formkörpern) nachhaltig verbessert werden, wenn die Ausgangsmischung in einem Platintiegel erschmolzen wird. Diese Beobachtung steht im Gegensatz zu einer aktuellen Untersuchung in der Literatur, in der die Herstellung von Supraleitermaterial der Zusammensetzung Bi$_2$Sr$_2$CaCu$_2$O$_8$ aus glasartigen Vorstufen beschrieben ist, die durch Schnellerstarrung von Schmelzen erzeugt wurden (T. G. Holesinger et al, Manuscript submitted to Journal of Materials Research, February 7, 1992). Die Autoren finden bei Verwendung von Korund- und Platintiegeln keine Unterschiede im supraleitenden Material. Kritische Stromdichten von erschmolzenen Keramikproben, bestehend aus den Oxiden von Bi, Sr, Ca und Cu und ggf. von Pb, liegen typischerweise im Bereich von 10$^2$ A/cm$^2$. Beim Aufschmelzen des gleichen Materials (also ebenfalls ohne Sulfatbeimengung) in einem Platintiegel konnten unter sonst gleichen Bedingungen (gleiche Temperaturbehandlungen, gleicher Materialquerschnitt von 0.5 cm$^2$) deutlich höhere Werte bis zu 1100 A/cm$^2$ erzielt werden.

Bei einem direkten Vergleich der kritischen Stromdichten verschiedener Keramikproben ist zu beachten, daß gleiche Querschnitte miteinander verglichen werden sollten, da bei größeren Querschnitten auch das Eigenmagnetfeld der Proben größer wird.

Dies führt bei sonst gleichen Materialeigenschaften zu einem Rückgang der kritischen Stromdichten für größere Querschnitte. Der Eigenfeldeffekt steigt auch mit dem durch die Probe fließenden Strom, d.h. er ist bei Material mit höherem Stromtragevermögen von größerer Bedeutung.

Beispielsweise wurde an einer stabförmigen Probe von 60 mm Länge mit 0.5 cm$^2$ Querschnitt, die durch Erschmelzen in einem Platintiegel und durch Vergießen in ein Quarzrohr hergestellt wurde, der kritische Strom zu 865 A/cm$^2$ bestimmt. Dagegen konnte an Stäbchen von 0.05 cm$^2$ Querschnitt, die anschließend längs aus dieser Probe herausgesägt wurden, reproduzierbar 2200 A/cm$^2$ gemessen werden. Bei der Angabe von kritischen Stromdichten sollten daher die Querschnitte der Proben, an denen diese Stromdichten bestimmt wurden, immer mit angegeben werden.

Der Eigenfeldeffekt hängt aber nicht nur vom absoluten Querschnitt der Probe, sondern auch von der Geometrie dieses Querschnittes ab. Beispielsweise ist es günstiger, anstelle von stabförmigen Massivteilen rohrförmige Teile zu verwenden.

Auch beim Aufschmelzen im Platintiegel konnten die gewünschten kritischen Stromdichten nicht mit befriedigender Reproduzierbarkeit erzielt werden. Überraschenderweise stellte sich jedoch heraus, daß noch höhere Absolutwerte und eine verbesserte Reproduzierbarkeit er-reicht werden können, wenn zwei Maßnahmen gleichzeitig getroffen werden: Das Aufschmelzen im Platintiegel und die Zugabe von SrSO$_4$ bzw. BaSO$_4$. Mit der Kombination beider Maßnahmen war es erstmals möglich, in Vollmassivstäben mit 8 mm Durchmesser Stromdichten von 1400 A/cm$^2$ zu erzielen.

Tabelle 2 listet Stromdichten auf, die an Stäben der Zusammensetzung Bi$_2$Sr$_2$CaCu$_2$O$_x$ (Durchmesser 8 mm, Länge 120 mm) mit unterschiedlichen Sulfatgehalten erzielt wurden.

Tabelle 2

| Einfluß des Strontiumsulfatgehaltes auf kritische Stromdichten (jc) beim Vergießen aus Platintiegeln | | | | | | |
|---|---|---|---|---|---|---|
| Zusatz SrSO$_4$ [Gew.-%] | 0 | 1 | 3 | 6 | 9 | 15 |
| jc [A/cm$^2$] | 658 | 658 | 753 | 921 | 945 | 1178 |
| | 732 | 763 | 878 | 951 | 1072 | 1283 |
| | 764 | 826 | 889 | 1046 | 1109 | 1317 |
| | 816 | 881 | 962 | 1046 | 1146 | 1380 |
| | 1107 | 941 | 1066 | 1167 | 1274 | 1420 |

Es wurden jeweils 5 Proben untersucht und die gemessenen Werte steigend aufgelistet.

Darüber hinaus sind die Standzeiten der Platintiegel im Vergleich zu den Korundtiegeln wesentlich höher. Selbst nach 20 Güssen aus einem Platinbecher wies dieser noch keine sichtbaren Beschädigungen auf. Statt das beschriebene Verfahren mit Tiegel aus Geräteplatin auszuführen, können auch solche aus Pt/Ir 97/3 bzw. 90/10 oder Pt/Au 95/5 oder Pt/Rh 90/10 bzw. 80/20 verwendet werden. Geeignet sind auch tiegelförmige Gefäße aus reinem Iridium.

Weiter wurde überraschenderweise gefunden, daß sich in Platintiegeln hergestellte Schmelzen in rohrförmige Kokillen mit dünneren Querschnitten vergießen lassen. Es wird daher vermutet, daß die Konsistenz der Schmelzen durch die nicht unerheblichen Al-gehalte beeinflußt wird.

Darüber hinaus lassen sich bei Verwendung dieser Tiegelmaterialien aus Edelmetallen die Schmelztemperaturen deutlich erhöhen. Das ist besonders dann wünschenswert, wenn die Zuschlagstoffe aus SrSO$_4$ oder BaSO$_4$, die über vergleichsweise hohe Schmelzpunkte zwischen 1500 und 1600°C verfügen, in größeren Anteilen zugesetzt werden. Die verwendete Temperatur hängt dann nur vom Erweichungspunkt des jeweils als Tiegelmaterial verwendeten Platinmetalls ab.

Im einzelnen ist das Verfahren der Erfindung nunmehr dadurch gekennzeichnet, daß man Oxide des Bismuts, Strontiums, Calciums, Kupfers und ggf. des Bleis im gewünschten molaren Verhältnis sowie zusätzlich 2 bis 30 Gew.-% Strontiumsulfat und/oder 1 bis 20 Gew.-% Bariumsulfat, jeweils berechnet auf das Gemisch der Oxide, innig vermischt, die Mischung in einem Tiegel aus einem Platinmetall bei Temperaturen von 870 bis 1600 °C schmilzt, die Schmelze in Kokillen gewünschter Form und Größe abgießt und darin langsam erstarren läßt, und die entstandenen Formkörper vom Kokillenmaterial befreit und 6 bis 200 Stunden bei Temperaturen von 700 bis 900 °C in sauerstoffhaltiger Atmosphäre glüht.

Darüber hinaus kann das Verfahren der Erfindung wahlweise oder bevorzugt noch dadurch gekennzeichnet sein,

EP 0 573 798 B1

daß

a) das Tiegelmaterial aus Platin, Iridium, Rhodium oder ihren Legierungen untereinander oder mit anderen Edelmetallen der 1. oder 8. Nebengruppe des Periodensystems der Elemente besteht;
b) man die Schmelze in eine waagerecht angeordnete, schnell drehende, rohrförmige Kokille abgießt;
c) das Oxidgemisch die Zusammensetzung $Bi_{2-a+b+c}$ $Pb_a$ $(Sr,Ca)_{3-b-c}$ $Cu_{2+d}$ $O_x$ mit a = 0 bis 0,7; b+c = 0 bis 0,5 , d = - 0,1 bis + 0,1; x = 7 bis 10, und ein Molverhältnis von Sr : Ca = (2,8 : 1) bis (1 : 2,8) aufweist;
d) man die Mischung bei Temperaturen von 1000 bis 1300 °C schmilzt;
e) man die Formkörper bei 750 bis 870 °C in sauerstoffhaltiger Atmosphäre glüht.

Beispiel 1 ( Vergleichsbeispiel):

Eine Mischung der Oxide von Bismut, Strontium, Calcium und Kupfer wurde im Mol-Verhältnis der Metalle von 2:2:1:2 bei 1030 °C in Sinterkorundtiegeln erschmolzen und in rohrförmige Quarzkokillen von 8 mm Durchmesser und 150 mm Länge, die an ihrem oberen Ende trichterförmig erweitert waren, vergossen. Zuvor wurden an den oberen und unteren Enden in den Kokillen ringförmig gebogene Silberblechstreifen plaziert, durch welche die Schmelze hindurchgegossen wurde, so daß sie anschließend fest in die erstarrte Schmelze integriert waren. Nach dem Tempern, jeweils 60 h bei 750 °C und 60 h bei 850 °C unter Luft, war das Material supraleitend und die Blechstreifen waren so mit dem Supraleiter verbunden, daß sie als Stromkontakte mit besonders geringen Kontaktwiderständen wirksam waren. An mehr als 10 von diesen Stäben wurden die kritischen Stromdichten bestimmt. Die Werte schwankten zwischen 38 und 195 $A/cm^2$.

Beispiel 2 (Vergleichsbeispiel):

Abweichend von Beispiel 1 wurden dem aufzuschmelzenden Oxidgemisch 3 Gew.-% $SrSO_4$ zugegeben und mehr als dreißig Stäbe hergestellt. Die kritischen Stromdichten lagen im Mittel bei etwa 500 $A/cm^2$, schwankten jedoch zwischen 250 und 900 $A/cm^2$.

Beispiel 3 (Vergleichsbeispiel):

Abweichend von Beispiel 1 wurden die Metalloxide in Tiegeln aus Pt/Ir 97/3 bei 1050 °C erschmolzen und stabförmige Massivteile mit Stromkontakten hergestellt. An zehn Proben der Länge 150 mm wurden die kritischen Stromdichten bestimmt. Die Werte lagen zwischen 450 und 1100 $A/cm^2$.

Beispiel 4:

Abweichend von Beispiel 3 wurden dem Oxidgemisch 3 Gew.-% $SrSO_4$ beigegeben. Die Stromdichten wurden an neun Proben zu 750 bis 1170 $A/cm^2$ bestimmt.

Beispiel 5:

Abweichend von Beispiel 3 wurden 9 Gew.-% $SrSO_4$ als Zuschlagstoff verwendet. Die Schmelztemperatur betrug 1050 °C. Die an sieben Proben ermittelten Stromdichten lagen zwischen 920 und 1274 $A/cm^2$.

Beispiel 6:

Abweichend von Beispiel 3 wurden 15 Gew.-% $SrSO_4$ zugemischt. Mehrfach konnten so an Massivstäben mit 8 mm Durchmesser kritische Stromdichten im Bereich von 1400 $A/cm^2$ erzielt werden.

Beispiel 7:

Abweichend von Beispiel 3 wurden jeweils 8 Gew.-% $BaSO_4$ als Zuschlagstoff verwendet. An fünf Proben wurden kritische Stromdichten zwischen 700 und 900 $A/cm^2$ ermittelt.

Beispiel 8 (zur Demonstration des Eigenfeldeffektes):

Nach Beispiel 4 wurde eine Probe von 60 mm Länge und 8 mm Durchmesser hergestellt, an welcher die kritische Stromdichte zu 865 $A/cm^2$ bestimmt wurde. Sowohl aus der Oberfläche als auch aus dem Inneren dieser Probe wurden Stäbchen mit einem Querschnitt von ca. 0.05 $cm^2$ über die gesamte Länge herausgetrennt. Die an vier aus dem inneren und äußeren Teil herausgetrennten Stäbchen gemessenen kritischen Stromdichten lagen zwischen 2150 und 2230 A/cm$^2$.

Beispiel 9:

Eine Mischung der Zusammensetzung gemäß Beispiel 2 wurde in einer Schale aus Geräteplatin erschmolzen und über eine schräg gestellte Rinne in eine waagerecht liegende, mit 800 Upm drehende Kokille der Abmessungen 35 mm Durchmesser und 200 mm Länge abgegossen. Zuvor wurden in der Kokille Blechstreifen aus Silber montiert, welche nach dem Tempern als Stromkontakte fungierten. Die kritische Stromdichte in dem Rohr betrug 2050 A bei einem Materialquerschnitt von 3 cm$^2$ (jc = 683 A/cm$^2$).

Beispiel 10:

Mischungen der Zusammensetzung aus Beispiel 5 wurden in Tiegeln aus Geräteplatin bzw. Korund bei jeweils 1080 °C erschmolzen und es wurde der Versuch unternommen, die Schmelze in Quarzrohre mit trichterförmig erweiterten Öffnungen der Durchmesser 5, 6, 7 und 8 mm zu vergießen. Dabei stellte sich heraus, daß aus dem im Platintiegel erschmolzenen Material jeweils Stäbe von 120 mm Länge erhalten werden konnten, während mit dem in Korund erschmolzenen Material nur Stäbe von 8 mm Durchmesser zu erhalten waren, da die Schmelze wesentlich zähflüssiger war.

**Patentansprüche**

1. Verfahren zur Herstellung eines Hochtemperatursupraleiters und daraus gebildeter Formkörper, bestehend aus Oxiden des Bismuts, Strontiums, Calciums, Kupfers und ggf. des Bleis sowie Sulfaten des Strontiums und/oder Bariums, dadurch gekennzeichnet, daß man Oxide des Bismuts, Strontiums, Calciums, Kupfers und ggf. des Bleis im gewünschten molaren Verhältnis sowie zusätzlich 2 bis 30 Gew.-% Strontiumsulfat und/oder 1 bis 20 Gew.-% Bariumsulfat, jeweils berechnet auf das Gemisch der Oxide, innig vermischt, die Mischung in einem Tiegel aus einem Platinmetall bei Temperaturen von 870 bis 1600 °C schmilzt, die Schmelze in Kokillen gewünschter Form und Größe abgießt und darin langsam erstarren läßt, und die entstandenen Formkörper vom Kokillenmaterial befreit und 6 bis 200 Stunden bei Temperaturen von 700 bis 900 °C in sauerstoffhaltiger Atmosphäre glüht.

2. Verfahren nach Anspruch 1, dadurch gekennzeichnet, daß das Tiegelmaterial aus Platin, Iridium, Rhodium oder ihren Legierungen untereinander oder mit anderen Edelmetallen der 1. oder 8. Nebengruppe des Periodensystems der Elemente besteht.

3. Verfahren nach Anspruch 1 oder 2, dadurch gekennzeichnet, daß man die Schmelze in eine waagerecht angeordnete, schnell drehende, rohrförmige Kokille abgießt.

4. Verfahren nach einem der Ansprüche 1 bis 3 , dadurch gekennzeichnet, daß das Oxidgemisch die Zusammensetzung Bi$_{2-a+b+c}$ Pb$_a$ (Sr,Ca)$_{3-b-c}$ Cu$_{2+d}$ O$_x$ mit a = 0 bis 0,7; b+c = 0 bis 0,5 , d = - 0,1 bis + 0,1; x = 7 bis 10, und ein Molverhältnis von Sr : Ca = (2,8 : 1) bis (1 : 2,8) aufweist.

5. Verfahren nach einem der vorgenannten Ansprüche, dadurch gekennzeichnet, daß man die Mischung bei Temperaturen von 1000 bis 1300 °C schmilzt.

6. Verfahren nach einem der vorgenannten Ansprüche, dadurch gekennzeichnet, daß man die Formkörper bei 750 bis 870 °C in sauerstoffhaltiger Atmosphäre glüht.

**Claims**

1. A process for producing a high-temperature superconductor and moldings formed therefrom, comprising oxides of bismuth, strontium, calcium, copper and optionally of lead as well as sulfates of strontium and/or barium, which comprises intimately mixing oxides of bismuth, strontium, calcium, copper and optionally of lead in the desired molar ratio, as well as additionally from 2 to 30% by weight of strontium sulfate and/or from 1 to 20% by weight of barium sulfate, each calculated according to the mixture of the oxides, melting the mixture in a crucible of a platinum metal at temperatures from 870 to 1600°C, pouring the melt into permanent molds of desired form and size and allowing it to solidify slowly therein, and freeing the moldings produced from the permanent mold material and annealing them for from 6 to 200 hours at temperatures from 700 to 900°C in an oxygen-containing atmosphere.

2. The process as claimed in claim 1, wherein the crucible material comprises platinum, iridium, rhodium or their alloys with each other or with other noble metals of the 1st or 8th subgroup of the Periodic Table of the Elements.

3. The process as claimed in claim 1 or 2, wherein the melt is poured into a horizontally disposed, rapidly rotating tubular permanent mold.

4. The process as claimed in any one of claims 1 to 3, wherein the oxide mixture has the composition $Bi_{2-a+b+c}Pb_a(Sr,Ca)_{3-b-c}Cu_{2+d}O_x$, with a = 0 to 0.7; b+c = 0 to 0.5 , d = -0.1 to +0.1; x = 7 to 10, and a molar ratio of Sr : Ca = (2.8 : 1) to (1 : 2.8).

5. The process as claimed in any one of the aforementioned claims, wherein the mixture is melted at temperatures from 1000 to 1300°C.

6. The process as claimed in any one of the aforementioned claims, wherein the moldings are annealed at from 750 to 870°C in an oxygen-containing atmosphere.

**Revendications**

1. Procédé pour la préparation d'un supraconducteur à haute température et d'objets moulés à partir de cette matière, laquelle consiste en oxydes du bismuth, du strontium, du calcium, du cuivre et le cas échéant du plomb, et en sulfates du strontium et/ou du baryum, caractérisé en ce que l'on mélange intimement des oxydes du bismuth, du strontium, du calcium, du cuivre et le cas échéant du plomb aux proportions molaires voulues, avec en outre 2 à 30 % en poids de sulfate de strontium et/ou 1 à 20 % en poids de sulfate de baryum, dans les deux cas par rapport au mélange des oxydes, on fond le mélange dans un creuset consistant en un métal de la série du platine à des températures de 870 à 1600°C, on coule la masse fondue dans des coquilles de forme et de dimensions voulues dans lesquelles on la laisse se solidifier lentement, on débarrasse les objets moulés du matériau de la coquille et on les cuit pendant 6 à 200 heures à des températures de 700 à 900°C en atmosphère contenant de l'oxygène.

2. Procédé selon revendication 1, caractérisé en ce que le matériau du creuset consiste en platine, iridium, rhodium ou leurs alliages entre eux ou avec d'autres métaux nobles du premier ou du huitième sous-groupe de la classification périodique des éléments.

3. Procédé selon revendication 1 ou 2, caractérisé en ce que la masse fondue est coulée dans une coquille tubulaire horizontale tournant rapidement.

4. Procédé selon une des revendications 1 à 3, caractérisé en ce que le mélange d'oxydes a une composition correspondant à la formule globale $Bi_{2-a+b+c} Pb_a (Sr,Ca)_{3-b-c} Cu_{2+d} O_x$ dans laquelle a = 0 à 0,7 ; b+c = 0 à 0,5 , d = -0,1 à + 0,1; x = 7 à 10 et le rapport molaire Sr/Ca va de 2,8 : 1 à 1 : 2,8.

5. Procédé selon une des revendications qui précèdent, caractérisé en ce que le mélange est fondu à des températures de 1000 à 1300°C.

6. Procédé selon une des revendications qui précèdent, caractérisé en ce que les objets moulés sont cuits à des températures de 750 à 870°C en atmosphère contenant de l'oxygène.